Europäisches Patentamt

European Patent Office

Office européen des brevets

(19)

(11) Veröffentlichungsnummer : **0 402 714 B1**

(12) **EUROPÄISCHE PATENTSCHRIFT**

(45) Veröffentlichungstag der Patentschrift :
07.09.94 Patentblatt 94/36

(51) Int. Cl.$^5$ : **H01L 39/14**

(21) Anmeldenummer : **90110422.4**

(22) Anmeldetag : **01.06.90**

(54) **Verfahren zur Reduzierung von Wirbelströmen in einem Supraleiterband und Supraleiteranordnung.**

(30) Priorität : **14.06.89 CH 2229/89**

(43) Veröffentlichungstag der Anmeldung :
**19.12.90 Patentblatt 90/51**

(45) Bekanntmachung des Hinweises auf die
Patenterteilung :
**07.09.94 Patentblatt 94/36**

(84) Benannte Vertragsstaaten :
**CH DE FR GB IT LI**

(56) Entgegenhaltungen :
**EP-A- 0 292 436**
**EP-A- 0 298 461**

(56) Entgegenhaltungen :
**SCIENCE, Band 242, Nr. 4877, 21. Oktober
1988, Seiten 391-399, Washington, US; E.B.
FORSYTH et al.:** "Energy loss mechanisms of
superconductors used in alternating-current
power transmission systems"
**IEEE TRANSACTIONS ON MAGNETICS, Band
25, Nr. 2, März 1989, Seiten 1807-1810, New
York, US; J.-T. ERIKSSON et al.:** "Economic
potential of applying HiTc superconductors to
magnetic energy storage"

(73) Patentinhaber : **ASEA BROWN BOVERI AG**
**Haselstrasse 16**
**CH-5401 Baden (CH)**

(72) Erfinder : **Dersch, Helmut, Dr.**
**Chilesteig 45**
**CH-8116 Würenlos (CH)**

## Beschreibung

Technisches Gebiet

Bei der Erfindung wird ausgegangen von einem Verfahren zur Reduzierung von Wirbelströmen in einem Supraleiterband nach dem Oberbegriff des Patentanspruchs 1 und von einer Supraleiteranordnung nach dem Oberbegriff des Patentanspruchs 2.

Stand der Technik

Mit dem jeweiligen Oberbegriff nimmt die Erfindung auf einen Stand der Technik Bezug, wie er aus der DE-A-2 654 924 bekannt ist. Um den Nachteil der Sprödigkeit gegenüber mechanischen Spannungen zu überwinden, wurde ein bandartiger Leiter bzw. Verbunddraht vorgeschlagen, dem eine supraleitende Schicht aus $Nb_3Sn$ um ein Band aus Nb herum angeordnet ist. Eine stabilisierende Schicht aus Kupfer oder einer Kupferlegierung ist um die supraleitende Schicht herum angeordnet, wobei eine üblicherweise gelötete Schicht zwischen der supraleitenden Schicht und der stabilisierenden Schicht angeordnet ist. Um die stabilisierende Schicht ist eine äusserste Isolierschicht angeordnet. Als nachteilig wird angegeben, dass das Band eine Instabilität in Form eines Flusssprunges aufgrund eines ungleichförmigen Magnetfeldes aufweist, das durch geometrische Anisotropie verursacht wird und zu Problemen bei der Entwicklung eines Magneten führt. Ferner ist es bekannt, einzelne Verbundkabel um ein rechteckiges oder rundes Rohr aus einem stabilisierenden und/oder einem Verstärkungsmaterial herumzuwickeln. Um bei Wechselstromanwendungen nachteilige Wirkungen aufgrund eines Kopplungsstromes zu vermeiden, werden die supraleitenden Adern oder Stränge verdrillt. Ein Kopplungsstrom kann auch dadurch vermindert werden, dass eine unterschiedliche Leitfähigkeit der jeweiligen Adern vorgesehen wird. Weiterhin kann ein erhöhter Kontaktwiderstand zwischen den betreffenden Adern eine Schleife des Kopplungsstromes in wirksamer Weise vermeiden. Um Wirbelstromverluste zu vermeiden, ist vorgesehen, dass ein stabilisierendes Metall, wie Kupfer, in einem isolierten, sowie voneinander getrennten Zustand, verwendet wird, anstatt in einer kontinuierlich massiven Form. Es kann auch vorgesehen sein, dass das Kupfer durch ein Material von hohem elektrischem Widerstand in einzelne Abschnitte unterteilt wird.

Nachteilig dabei ist die relativ aufwendige Herstellung von Verbundkabeln.

Zum einschlägigen Stand der Technik wird ferner auf eine Veröffentlichung von T. R. Dinger et al., Direct Observation of Electronic Anisotropy in Single-Crystal $Y_1Ba_2Cu_3O_{7-x}$, in der amerikanischen Zeitschrift: Physical Review Letters, Vol. 58, Nr. 25, 22. 6. 1987, 5. 2687 - 2690, verwiesen. Dort wird das elektrische Verhalten von anisotropen Hochtemperatur-Oxidsupraleitern beschrieben, die in einer bestimmten Richtung eine kleinere kritische Stromdichte aufweisen als in allen anderen Richtungen.

Die Herstellung orientierter Filme von Hochtemperatur-Supraleitern ist aus einer Veröffentlichung von S. Jin et al., High critical currents in Y-Ba-Cu-O superconductors, in der amerikanischen Zeitschrift: Appl. Phys. Lett. 52 (24), 13. 6. 1988, S. 2074 - 2076 bekannt.

Darstellung der Erfindung

Die Erfindung, wie sie in den Patentansprüchen 1 und 2 definiert ist, löst die Aufgabe, ein Verfahren und eine Supraleiteranordnung der eingangs genannten Art anzugeben, die auf einfachere Art eine Reduzierung von Wechselstromverlusten bei Hochtemperatur-Supraleitern gewährleistet.

Ein Vorteil der Erfindung besteht darin, dass bei Leitern für Anwendungen in extern vorgegebenen Magnetfeldern (Transformator, Generator, Maschine usw.) die Wirbelströme auf eine kleine Länge des Leiters begrenzt sind. Dies erreicht man durch periodisches Verdrehen der Kristallebenen. Es werden keine aufwendig herzustellende Verbund-Supraleiter mit dünnen supraleitenden Fäden benötigt, welche in eine Metallmatrix eingebettet und verdreht werden müssen, um Kopplungsverluste zwischen den Fäden zu vermeiden.

Die elektrische Anisotropie von Hochtemperatur-Supraleitern, die bisher als Hindernis für deren technische Anwendung angesehen wurde, wird hier ausgenutzt.

Kurze Beschreibung der Zeichnungen

Die Erfindung wird nachstehend anhand von Ausführungsbeispielen erläutert. Es zeigen:

Fig. 1    eine Prinzipdarstellung eines Abschnittes eines Metallträgers, der mit zwei Bändern aus einem elektrisch anisotropen Hochtemperatur-Supraleiter spiralförmig beschichtet ist,

Fig. 2    eine Darstellung der Wirbelströme in einem elektrisch anisotropen Hochtemperatur-Supraleiter und

Fig. 3    einen Zweischichtleiter aus einem elektrisch anisotropen Hochtemperatur-Supraleiter, der auf ein Metallband aufgetragen ist und in periodischen Abständen Stege oder Nuten zur Wirbelstrombegrenzung aufweist.

Wege zur Ausführung der Erfindung

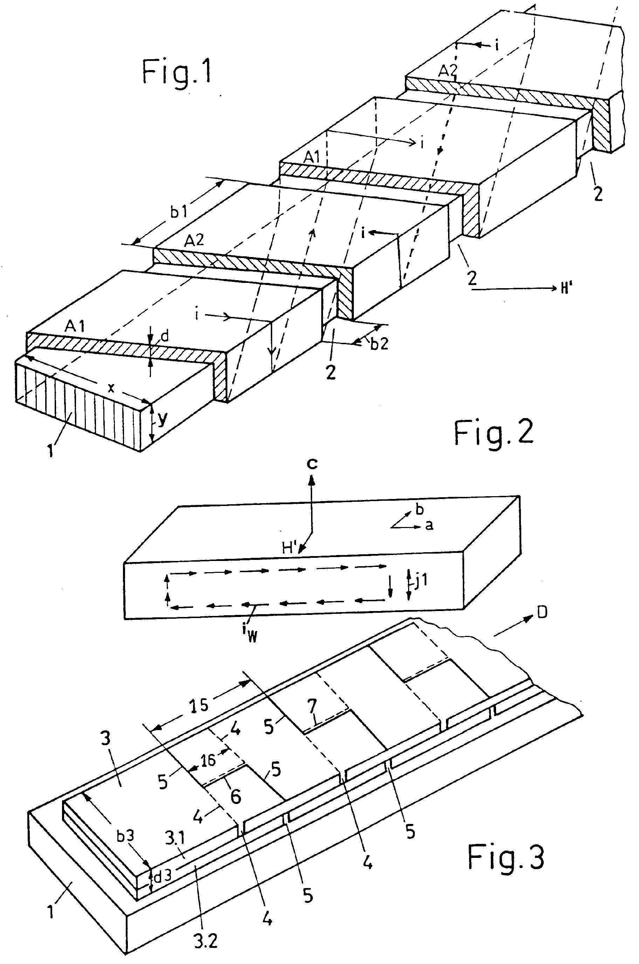

Ein in Fig. 1 ausschnittsweise und im Prinzip dargestellter, quaderförmiger Träger bzw. Schichtträger (1) aus Metallblech hat eine Breite (x) im Bereich von 0,2 cm - 10 cm, vorzugsweise im Bereich von 2 cm - 3 cm, und eine Dicke (y) im Bereich von 0,05 mm - 2 mm, vorzugsweise im Bereich von 0,4 mm - 0,6 mm. Dieser Träger (1) ist mit 2 bifilaren Bändern (A1) und (A2) aus einem elektrisch anisotropen Hochtemperatur-Oxidsupraleiter, wie z.B. $YBa_2Cu_3O_{7-x}$, spiralförmig beschichtet. Die Schichtdicke (d) dieser Bänder (A1, A2) ist kleiner als deren Breite (b1). Zwischen benachbarten Bändern (A1) und (A2) befindet sich ein Abstand bzw. eine Nut (2) von einer Breite (b2) im Bereich von 0,1 mm - 1 mm. Dadurch wird ein mit (i) bezeichneter Strom gezwungen, den Träger (1) spiralförmig zu umkreisen, und zwar im Band (A1) nach rechts oben und im Band (A2) entgegengesetzt nach links unten in der Darstellung gemäss Fig. 1. Durch Beschichtung dieser Struktur mit 2 gleichen Bändern, die im entgegengesetzten Sinn vom Strom (i) durchflossen werden, können unerwünschte Induktivitäten vermieden werden.

Die Beschichtung mit dem Supraleiter erfolgt derart, dass die kristallographische c-Achse des Materials überall einen Winkel von 90° ± 5° mit der Oberfläche des Schichtträgers (1) bildet. Ein geeignetes Verfahren ist in der eingangs genannten Veröffentlichung von S. Jin et al. beschrieben.

Fig. 2 zeigt schematisch einen elektrisch anisotropen Hochtemperatur-Supraleiter mit einer Vorzugsrichtung (c), in der und entgegengesetzt zu der die kritische Stromdichte (j1) kleiner ist als in allen anderen Richtungen (a, b). Mit Pfeilen ist ein Wirbelstrom ($i_W$) angedeutet, der in einer Ebene senkrecht zur Richtung eines Magnetfelds (H') im Supraleiter fliesst. Eine geringere Leitfähigkeit in Richtung der kritischen Stromdichte (j1) begrenzt die Stärke der Wirbelströme.

Die Supraleiteranordnung gemäss Fig. 1 wird im Anwendungsfall bezüglich des Magnetfeldes (H') derart positioniert, dass sich die schmalen Seitenflächen des Trägers (1) in einer senkrechten Position von 90° ± 5° zum Magnetfeld befinden.

Wirbelströme ($i_W$) in den Supraleiterbändern (A1, A2) fliessen im Bereich der breiten Flächen des Trägers (1) abwechselnd durch Bereiche in dieser Vorzugsrichtung (c) und periodisch durch Bereiche, die entgegengesetzt dazu orientiert, d.h. um 180° gedreht sind. Im Bereich der schmalen Seitenflächen des Trägers (1) fliessen Wirbelströme ($i_W$) in der Ebene (a, b), so dass hier der gewünschte Effekt der Reduzierung der Wirbelströme nicht eintritt.

Fig. 3 zeigt eine andere Ausführungsart der Erfindung, bei der eine elektrisch anisotrope supraleitende Schicht (3) bzw. ein supraleitender Zweischichtleiter (3), der aus zwei gleich dicken Schichten (3.1) und (3.2) zusammengesetzt gedacht werden kann, tatsächlich aber aus einer Schicht besteht, auf einem nichtsupraleitenden Träger (1) abgeschieden ist. Die supraleitende Schicht (3) hat eine Breite (b3) im Bereich von 2 cm - 3 cm und eine Dicke (d3) im Bereich von 0,01 mm - 1 mm, vorzugsweise im Bereich von 0,1 mm - 0,4 mm. In Längsrichtung (D) der Schicht (3) sind in gleichmässigen oder Periodenabständen (15) in der unteren Halbschicht (3.2) nichtsupraleitende Trennzonen, d. h. Stege oder Aussparungen bzw. Nuten (5), welche von der Auflagefläche bis zur halben Dicke in die Schicht (3) hineinragen, und in der oberen Halbschicht (3.1) nichtsupraleitende Trennzonen, d. h. Stege oder Aussparungen bzw. Nuten (4) vorgesehen, welche von der oberen Fläche der Schicht (3) bis zur Schichtmitte bzw. zur halben Dicke der Schicht in diese hineinragen. Stege und Nuten (4, 5) sind, von der Oberfläche gesehen, stuhl- bzw. stufenförmig ausgebildet, mit je einer nichtsupraleitenden Trennzone, d. h. einem Längssteg oder einer Längsnut (6) in der unteren Halbschicht (3.2) und einer parallel dazu verlaufenden nichtsupraleitenden Trennzone, d. h. einem Längssteg oder einer Längsnut (7) in der oberen Halbschicht (3.1) in Längsrichtung (D) in der Mitte der Schicht (3). Insgesamt stellen zu einer Periode bzw. zu einem Absatz gehörende Stege oder Nuten (4, 5) die Form eines H dar, wobei der gestrichelt gezeichnete Steg bzw. die Nut (4) nur in der oberen Hälfte der Supraleiterschicht (3) und der ausgezogen gezeichneten Steg bzw. die Nut (5) nur in der unteren Hälfte der Supraleiterschicht (3) verlaufen. Bezüglich der c-Achse gilt das oben Gesagte. Im Querbalken des H reicht die supraleitende Trennzone (6, 7) durch die ganze supraleitende Schicht (3). Die Breite der nichtsupraleitenden Trennzonen, Stege oder Nuten (4, 5, 6, 7) ist ≦ 0,5 mm.

Der Träger (1) ist 2 cm - 3 cm breit, 0,1 mm - 2 mm dick und ggf. über 1 km lang.

Statt dieses Zweibandleiters könnte auch ein nicht dargestellter Einschichtleiter vorgesehen sein, bei dem die c-Achse des aufgebrachten Supraleiters periodisch um 180° gedreht ist. Dabei bilden die c-Achse und die Schichtträgeroberfläche einen Winkel von 90° ± 5° und 270° ± 5°, der periodisch mit einer Periodenlänge von Breite (x) plus Dicke (y) des Schichtträgers (1) zwischen diesen beiden Werten wechselt.

Die in Fig. 3 dargestellte Supraleiteranordnung ist besonders als Leiter (Kabel) zur Stromübertragung geeignet, bei dem nur die Eigenfeldverluste reduziert werden müssen. Eine Verdrillung wird hier simuliert durch einen Zweischichtleiter, bei dem die stromdurchflossenen Schichten periodisch vertauscht werden. Die c-Achse des aufgebrachten Supraleiters ist senkrecht zur Oberfläche der Schicht (3) orientiert. Die Nuten und Stege (4, 5) bewirken, dass jeder Strompfad periodisch zwischen Oberschicht (3.1) und Unterschicht (3.2) wechselt. Da Eigenfelder des Stroms dadurch gekennzeichnet sind, dass sie unterschiedliche, entgegengesetzte Richtung in der Ebene der Oberschicht (3.1 und der Unterschicht (3.2) besitzen, werden Wirbelströme effektiv auf die Länge (15) im Periodenabstand der Stege (5) begrenzt.

Wichtig ist, dass Wirbelströme auf eine Länge im Supraleiter kleiner als eine kritische Länge $l_c$ begrenzt werden, mit

$$l_c = 4 \, ((r \cdot \rho \cdot j_c)/(dB/dt))^{1/2},$$

$\rho$ = elektrischer Widerstand des Supraleiters in c-Richtung bei Überschreiten der kritischen Stromdichte in dieser Richtung, r = halbe Banddicke, $j_c$ = kritische Stromdichte in a,b-Richtung, B = magnetische Induktion, t = Zeit, um Kopplungsverluste wirksam zu unterdrücken. Dabei muss die c-Richtung der supraleitenden Schicht (A1, A2) im überwiegenden Teil senkrecht zum Magnetfeld (H) ausgerichtet sein. Andernfalls werden Wirbelströme in der a b-Ebene induziert, welche zu höheren Verlusten führen. Bei der Anordnung gemäss Fig. 1 muss der Abstand $2 \cdot (b1 + b2) \leqq l_c$ sein. Bei der Anordnung gemäss Fig. 3 muss $l5 \leqq l_c$ sein.

## Patentansprüche

1. Verfahren zur Reduzierung von Wirbelströmen in mindestens einem anisotropen, stromdurchflossenen Hochtemperatur-Oxid-Supraleiterband (A1, A2, 3)

a) das in einer Vorzugsrichtung (c) eine kleinere kritische Stromdichte (j1) aufweist, als in allen anderen Richtungen (a, b), und

b) auf einem nichtsupraleitenden Schichtträger (1) als Schicht aufgebracht ist

dadurch gekennzeichnet,

c) dass die im Supraleiterband erzeugten Wirbelströme in periodischen Abständen, die kleiner als eine vorgebbare kritische Länge sind, streckenweise durch Bereiche des Supraleiterbandes geführt werden, die in Vorzugsrichtung (c) des Supraleiters und um 180° gedreht entgegengesetzt dazu orientiert sind, wobei für die kritische Länge gilt:

$$l_c = 4 \, ((r \cdot \rho \cdot j_c)/(dB/dt))^{1/2},$$

$\rho$ = elektrischer Widerstand des Supraleiters in c-Richtung bei Überschreiten der kritischen Stromdichte in dieser Richtung, r = halbe Banddicke, $j_c$ = kritische Stromdichte in einer zur c-Richtung senkrechten a,b-Richtung, B = magnetische Induktion, t = Zeit.

2. Supraleiteranordnung mit mindestens einem anisotropen stromduchflossenen Hochtemperatur-Oxid-Supraleiterband (A1, A2, 3),

a) das in einer Vorzugsrichtung (c) eine kleinere kritische Stromdichte (j1) aufweist, als in allen anderen Richtungen (a, b), und

b) auf einem nichtsupraleitenden Schichtträger (1) als Schicht aufgebracht ist

c) wobei die Vorzugsrichtung (c) und die Schichtträgeroberfläche einen Winkel von 90° ± 5° bilden, dadurch gekennzeichnet,

d) dass das Supraleiterband in Richtung eines durch das Supraleiterband fliessenden Stromes in periodischen Abständen (2 (b1 + b2); 15) nacheinander nach Stromflussbereichen normaler Stromdichte Stromflussbereiche mit kleinerer kritischer Stromdichte (j1) aufweist, wobei diese Abstände kleiner als eine kritische Länge sind, für die gilt:

$$l_c = 4 \, ((r \cdot \rho \cdot j_c)/(dB/dt))^{1/2},$$

$\rho$ = elektrischer Widerstand des Supraleiters in c-Richtung bei Überschreiten der kritischen Stromdichte in dieser Richtung, r = halbe Banddicke, $j_c$ = kritische Stromdichte in einer zur c-Richtung senkrechten a,b-Richtung, B = magnetische Induktion, t = Zeit.

3. Supraleiteranordnung nach Anspruch 2, dadurch gekennzeichnet,

a) dass das mindestens eine Supraleiterband (A1, A2) den Schichtträger (1) spiralförmig umgibt und

b) dass der Schichtträger (1) im Querschnitt im wesentlichen rechteckförmig ausgebildet ist, wobei dessen Breite (x) grösser als dessen Dicke (y) ist.

4. Supraleiteranordnung nach Anspruch 3, dadurch gekennzeichnet,

a) dass der Schichtträger (1) eine Breite (x) im Bereich von 1 cm - 5 cm und

b) eine Dicke (y) im Bereich von 0,1 mm - 2 mm aufweist.

5. Supraleiteranordnung nach Anspruch 3, dadurch gekennzeichnet,
a) dass der Schichtträger (1) eine Breite (x) im Bereich von 2 cm - 3 cm und
b) eine Dicke (y) im Bereich von 0,4 mm - 0,6 mm aufweist.

6. Supraleiteranordnung nach Anspruch 3 oder 4 oder 5, dadurch gekennzeichnet, dass benachbarte Wicklungen des mindestens einen Supraleiterbandes (A1, A2) zueinander einen vorgebbaren Bandabstand (b2) im Bereich von 0,1 mm - mm aufweisen.

7. Supraleiteranordnung nach Anspruch 2, dadurch gekennzeichnet,
a) dass die supraleitende Schicht (3) in Längsrichtung (D) in vorgebbarem Abstand (15) periodisch versetzt nichtsupraleitende Trennzonen, Nuten oder Stege (5) aufweist, welche von der Auflageseite der supraleitenden Schicht (3) in diese supraleitende Schicht hineinragen, und
b) dass sie in diesem vorgebbaren Abstand (15) periodisch nichtsupraleitende Trennzonen, Nuten oder Stege (4) aufweist, welche sich von der Oberfläche der supraleitenden Schicht (3) in diese Schicht erstrecken.

8. Supraleiteranordnung nach Anspruch 7, dadurch gekennzeichnet,
a) dass sich die nichtsupraleitenden Trennzonen, Nuten oder Stege (4, 5) wechselseitig senkrecht zur Längsrichtung (D) der supraleitenden Schicht (3) jeweils bis zur Mitte dieser Schicht erstrecken und
b) dass über eine Strecke (15) vorgebbarer Länge nichtsupraleitende Trennzonen, Längsnuten oder Längsstege (6, 7) in der Mitte in Längsrichtung (D) der Schicht (3) verlaufen
c) in der gesamten Dicke (d3) der supraleitenden Schicht (3).

9. Supraleiteranordnung nach einem der Ansprüche 7 bis 9, dadurch gekennzeichnet,
a) dass die supraleitende Schicht (3) eine Breite (b3) im Bereich von 2 cm - 3 cm und
b) eine Dicke (d3) im Bereich von 0,01 mm - 1 mm,
c) insbesondere von 0,1 mm - 0,4 mm aufweist, und
d) dass die nichtsupraleitende Trennzone, Nut oder der Steg (4, 5, 6, 7) eine Breite kleiner oder gleich 0,5 mm hat.

10. Supraleiteranordnung nach einem der Ansprüche 7 bis 9, dadurch gekennzeichnet, dass die von der Oberfläche der supraleitenden Schicht (3) in diese hineinragenden nichtsupraleitenden Trennzonen, Nuten oder Stege (4) sowie die von der Unterseite der Auflagefläche der supraleitenden Schicht (3) in diese hineinragenden nichtsupraleitenden Trennzonen, Nuten oder Stege (5) jeweils stuhl- bzw. stufenförmig ausgebildet sind, derart, dass sie gemeinsam die Form eines H aufweisen, wobei der Querbalken des H durch die in Längsrichtung (D) der supraleitenden Schicht (3) verlaufenden nichtsupraleitenden Trennzonen, Längsnuten oder Längsstege (6, 7) gebildet wird.

## Claims

1. Process for reducing eddy currents in at least one anisotropic current-carrying high-temperature oxide superconductor strip (A1, A2, 3)
a) which in a preferred direction (c) has a smaller critical current density (j1) than in all other directions (a, b), and
b) is applied as a layer on a non-superconducting substrate (1)
characterized in that
c) the eddy currents generated in the superconductor strip are conducted segmentally at periodic intervals, which are smaller than a predeterminable critical length, through regions of the superconductor strip that are oriented in the preferred direction (c) of the superconductor and, rotated by 180°, oppositely thereto, it being the case that it holds for the critical length that:

$$I_c = 4\,((r.\rho.j_c)/(dB/dt))^{1/2},$$

$\rho$ = electrical resistance of the superconductor in the c-direction upon overshooting of the critical current density in this direction, r = half strip thickness, $j_c$ = critical current density in an a,b-direction perpendicular to the c-direction, B = magnetic induction, and t = time.

2. Superconductor arrangement with at least one anisotropic current-carrying high-temperature oxide superconductor strip (A1, A2, 3),

a) which has in a preferred direction (c) a smaller critical current density (j1) than in all other directions (a, b) and

b) is applied on a non-superconducting substrate (1) as a layer,

c) the preferred direction (c) and the substrate surface forming an angle of 90° ± 5°, characterized in that,

d) in the direction of a current flowing through the superconductor strip, the superconductor strip has, at periodic intervals (2 (b1 + b2); 15) after one another, current flow regions of normal current density followed by current flow regions with a smaller critical current density (j1), it being the case that these intervals are smaller than a critical length for which it holds that:

$$l_c = 4 ((r.\rho.j_c)/(dB/dt))^{1/2},$$

$\rho$ = electrical resistance of the superconductor in the c-direction upon overshooting of the critical current density in this direction, r = half strip thickness, $j_c$ = critical current density in an a,b-direction, perpendicular to the c-direction, B = magnetic induction, and t = time.

3. Superconductor arrangement according to Claim 2, characterized in that

a) at least one superconductor strip (A1, A2) surrounds the substrate (1) spirally, and

b) the substrate (1) is constructed in an essentially rectangular fashion in cross-section, its width (x) being larger than its thickness (y).

4. Superconductor arrangement according to Claim 3, characterized in that

a) the substrate (1) has a width (x) in the region of 1 cm - 5 cm, and

b) a thickness (y) in the region of 0.1 mm - 2 mm.

5. Superconductor arrangement according to Claim 3, characterized in that

a) the substrate (1) has a width (x) in the region of 2 cm - 3 cm, and

b) a thickness (y) in the region of 0.4 mm - 0.6 mm.

6. Superconductor arrangement according to Claim 3 or 4 or 5, characterized in that neighbouring windings of the at least one superconductor strip (A1, A2) have a mutual predeterminable strip interval (b2) in the region of 0.1 mm - 1 mm.

7. Superconductor arrangement according to Claim 2, characterized in that

a) the superconducting layer (3) has non-superconducting separation zones, grooves or webs (5) periodically offset at a predeterminable interval (15) in the longitudinal direction (D), which project from the supporting side of the superconducting layer (3) into this superconducting layer, and

b) said layer (3) has separation zones, grooves or webs (4), which are periodically non-superconducting at this predeterminable interval (15) and extend from the surface of the superconducting layer (3) into this layer.

8. Superconductor arrangement according to Claim 7, characterized in that

a) the non-superconducting separation zones, grooves or webs (4, 5) extend alternately perpendicularly to the longitudinal direction (D) of the superconducting layer (3) up to the middle of this layer in each case, and

b) separation zones, longitudinal grooves or longitudinal webs (6, 7) which are non-superconducting over a segment (15) of predeterminable length, extend in the middle in the longitudinal direction (D) of the layer (3)

c) in the entire thickness (d3) of the superconducting layer (3) [sic].

9. Superconductor arrangement according to one of Claims 7 to 9 [sic], characterized in that

a) the superconducting layer (3) has a width (b3) in the region of 2 cm - 3 cm and

b) a thickness (d3) in the region of 0.01 mm - 1 mm,

c) particularly of 0.1 mm - 0.4 mm, and

d) the non-superconducting separation zone, groove or web (4,5,6,7) has a width smaller than or equal to 0.5 mm.

10. Superconductor arrangement according to one of Claims 7 to 9, characterized in that the non-superconducting separation zones, grooves or webs (4) which project from the surface of the superconducting layer (3) into the latter, and the non-superconducting separation zones, grooves or webs (5) which project from the underside of the supporting surface of the superconducting layer (3) into the latter are constructed in each case in the form of seats or steps in such a way that together they have the form of an H, the crossbar of the H being formed by the non-superconducting separation zones, longitudinal grooves or longitudinal webs (6, 7) extending in the longitudinal direction (D) of the superconducting layer (3).

**Revendications**

1. Procédé de réduction de courants parasites dans au moins une bande supraconductrice anisotrope à haute température à base d'oxyde traversée par un courant (A1, A2, 3),

   a) qui, dans une orientation préférentielle (c), présente une densité de courant critique (j1) plus faible que dans toutes les autres orientations (a, b), et

   b) est appliquée en couche sur un porteur de couches non supraconducteur (1),

       caractérisé en ce que :

   c) les courants parasites produits dans la bande supraconductrice sont amenés à traverser, par endroits, à intervalles périodiques inférieurs à une longueur critique prédéfinissable, des régions de la bande supraconductrice qui sont orientées dans l'orientation préférentielle (c) du supraconducteur et, après une rotation de 180°, dans la direction opposée à celle-ci, la longueur critique étant :

$$l_c = 4 \left( (r.\rho.j_c)/(dB/dt) \right)^{1/2}$$

   où $\rho$ = résistance électrique du supraconducteur dans l'orientation c en cas de dépassement de la densité de courant critique dans cette orientation, r = demi-épaisseur de bande, $j_c$ = densité de courant critique dans une orientation a,b perpendiculaire à l'orientation c, B = induction magnétique, t = temps.

2. Arrangement supraconducteur avec au moins une bande supraconductrice anisotrope à haute température à base d'oxyde traversée par un courant (A1, A2, 3),

   a) qui, dans une orientation préférentielle (c), montre une densité de courant critique (j1) plus faible que dans toutes les autres orientations (a, b), et

   b) est appliquée en couche sur un porteur de couches non supraconducteur (1),

   c) l'orientation préférentielle (c) et la surface du porteur de couches formant un angle de 90° ± 5°,

       caractérisé en ce que :

   d) la bande supraconductrice présente dans l'orientation d'un courant traversant la bande supraconductrice, à intervalles périodiques consécutifs (2(b1 + b2); 15) après des zones de flux de courant de densité de courant normale, des zones de flux de courant avec une densité de courant critique plus faible (j1), ces intervalles étant inférieurs à une longueur critique :

$$l_c = 4 \left( (r.\rho.j_c)/(dB/dt) \right)^{1/2}$$

   où $\rho$ = résistance électrique du supraconducteur dans l'orientation c en cas de dépassement de la densité de courant critique dans cette orientation, r = demi-épaisseur de bande, $j_c$ = densité de courant critique dans une orientation a,b perpendiculaire à l'orientation c, B = induction magnétique, t = temps.

3. Arrangement supraconducteur selon la revendication 2, caractérisé en ce que :

   a) au moins une bande supraconductrice (A1, A2) entoure en spirale le porteur de couches (1), et

   b) le porteur de couches (1) est conçu avec une section de forme essentiellement rectangulaire, sa largeur (x) étant supérieure à son épaisseur (y).

4. Arrangement supraconducteur selon la revendication 3, caractérisé en ce que :

   a) le porteur de couches (1) présente une largeur (x) de l'ordre de 1 cm - 5 cm, et

   b) une épaisseur (y) de l'ordre de 0,1 mm - 2 mm.

5. Arrangement supraconducteur selon la revendication 3, caractérisé en ce que :

   a) le porteur de couches (1) présente une largeur (x) de l'ordre de 2 cm - 3 cm, et

   b) une épaisseur (y) de l'ordre de 0,4 mm - 0,6 mm.

6. Arrangement supraconducteur selon la revendication 3, 4 ou 5, caractérisé en ce que des enroulements voisins d'au moins une bande supraconductrice (A1, A2) présentent l'un par rapport à l'autre un écart de bande prédéfinissable (b2) de l'ordre de 0,1 mm - 1 mm.

7. Arrangement supraconducteur selon la revendication 2, caractérisé en ce que :

   a) la couche supraconductrice (3) présente en orientation longitudinale (D) dans un intervalle prédéfinissable (15) des zones de séparation, rainures ou nervures (5) non supraconductrices périodiquement décalées qui pénètrent depuis la face d'application de la couche supraconductrice (3) dans cette dernière, et

b) il présente périodiquement dans cet intervalle prédéfinissable (15) des zones de séparation, nervures ou rainures (4) non supraconductrices qui s'étendent depuis la surface de la couche (3) supraconductrice dans cette couche.

8. Arrangement supraconducteur selon la revendication 7, caractérisé en ce que :

a) les zones de séparation, rainures ou nervures (4, 5) non supraconductrices s'étendent en alternance perpendiculairement par rapport à l'orientation longitudinale (D) de la couche supraconductrice (3) respectivement jusqu'au milieu de cette couche, et

b) des zones de séparation, rainures longitudinales ou nervures longitudinales (6, 7) non supraconductrices s'étendent sur une zone (15) de longueur prédéfinissable au milieu de la couche (3) en orientation longitudinale (D) de celle-ci,

c) dans toute l'épaisseur (d3) de la couche supraconductrice (3).

9. Arrangement supraconducteur selon l'une quelconque des revendications 7 à 9, caractérisé en ce que :

a) la couche supraconductrice (3) présente une largeur (b3) de l'ordre de 2 cm - 3 cm, et

b) une épaisseur (d3) de l'ordre de 0,01 mm - 1 mm,

c) en particulier de 0,1 mm - 0,4 mm, et

d) en ce que la zone de séparation, rainure ou nervure (4, 5, 6, 7) non supraconductrice montre une largeur inférieure ou égale à 0,5 mm.

10. Arrangement supraconducteur selon l'une quelconque des revendications 7 à 9, caractérisé en ce que les zones de séparation, rainures ou nervures (4) non supraconductrices formées à la surface de la couche supraconductrice (3) et pénétrant dans celle-ci ainsi que les zones de séparation, rainures ou nervures (5) non supraconductrices formées à la face inférieure de la surface d'application de la couche supraconductrice (3) et pénétrant dans celle-ci sont respectivement conçues en forme de chaise ou de gradin, de sorte qu'elles présentent ensemble la forme d'un H, la barre transversale du H étant formée par les zones de séparation, rainures longitudinales ou nervures longitudinales (6, 7) non supraconductrices s'étendant en orientation longitudinale (D) de la couche supraconductrice (3).

Fig.1

Fig.2

Fig.3